# EUROPEAN PATENT SPECIFICATION

(11) **EP 0 722 121 B1**
(45) Date of publication and mention of the grant of the patent: **28.04.1999**
(21) Application number: 96100069.2
(22) Date of filing: 04.01.1996
(51) Int. Cl.: G03F 7/023

(54) **Photosensitive planographic printing plate**
Lichtempfindliche Flachdruckplatte
Plaque d'impression planographique photosensible

(30) Priority: 12.01.1995 JP 3294/95
(43) Date of publication of application: 17.07.1996
(73) Proprietor: FUJI PHOTO FILM CO., LTD., Kanagawa-ken (JP)
(72) Inventor: Toyama, Tadao, c/o Fuji Photo Film Co.,Ltd., Haibara-gun, Shizuoka (JP); Nakanishi, Haruo, c/o Fuji Photo Film Co.,Ltd., Haibara-gun, Shizuoka (JP)
(74) Representative: Grünecker, Kinkeldey, Stockmair & Schwanhäusser Anwaltssozietät

(56) References cited:
- DE-A- 3 733 421
- GB-A- 2 172 117
- US-A- 5 132 376
- PATENT ABSTRACTS OF JAPAN vol. 010 no. 045 (P-430) ,21 February 1986 & JP-A-60 189739 (NIPPON GOSEI GOMU KK) 27 September 1985,

## Description

The present invention relates to a positive type photosensitive planographic printing plate which is suitable for development by a developer of relatively low pH.

The positive type photosensitive planographic printing plates which have been widely used have a photosensitive layer comprising an o-quinonediazide compound formed on an aluminum plate as a support. The o-quinonediazide compound is known to be converted into a carboxylic acid by exposing to ultraviolet light. When an exposed photosensitive planographic printing forme is developed with an aqueous alkali, only exposed areas of the photosensitive layer are removed to disclose the surface of the support. The disclosed areas (nonimage areas) of the surface of the aluminum support retain water and repel oily ink, because of water wettability of the surface, whereas areas not removed (image areas) by development repel water and retain ink because of ink receptivity of the photosensitive layer.

A cresol novolak resin has been usually used as a binder for the above-mentioned o-quinonediazide compound (hereinafter referred to as a "binder"). Therefore, strongly alkaline silicates have been generally used for a developer having about pH 13 which can dissolve the cresol novolak resin.

Although various aqueous alkalis are known as such developers for the positive type photosensitive planographic printing formes, the most suitable aqueous solutions are those of silicates such as sodium silicate and potassium silicate. The reason for this is that a ratio of silicon dioxide, SiO₂, to an alkali metal oxide, M₂O, in which SiO₂ and M₂O are constituent parts of a silicate (the ratio is generally represented by a molar ratio [SiO₂]/[M₂O]) and the concentration are considered to be able to regulate development characteristics to some extent.

However, such developers of high pH exert a stimulative action on the skin and the mucous membrane to require handling with great care.

In order to solve this problem, various attempts have been made to lower pH of the developer for the positive type photosensitive planographic printing plate. However, the positive type presensitized plate which can be developed at pH 12.5 or lower and the developer for it are not yet commercially available. The main reason is sought in difficulty in satisfying both the development characteristics and the image strength of the photosensitive layer. That is, the unexposed areas (image areas) of a photosensitive layer which can be developed at pH 12.5 or lower are insufficient in physical strength and are rapidly worn away on printing, resulting in lowering the impression capacity of the sensitized plate. Further, the image areas are chemically unstable as well. The image areas which are wiped by use of an ink cleaning agent or a plate cleaner on printing receive damage, resulting in insufficient impression capacity (Hereinafter referred to as "chemical resistance") To improve the physical and chemical strength of the image areas, various o-quinonediazide compounds and binders have been proposed in JP-A-60-143345 (the term "JP-A" as used herein means an "unexamined published Japanese patent application"), JP-A-61-107352, JP-A-62-133452, JP-A-62-133461, and JP-B-3-15176 (the term "JP-B" as used herein means an "examined Japanese patent publication"). However, all photosensitive layers described in these specifications are those which are only developed at about pH 13.

Further, to improve the impression capacity, JP-A-61-205933 has disclosed a photosensitive composition comprising an o-quinonediazide compound and a novolak resin having a weight average molecular weight of 6.0×10³ to 2.0×10⁴. However, when the novolak resin is a customary phenol-formaldehyde resin which is not co-condensed with a monomer having chemical resistance such as cresol, a photosensitive layer formed of such a resin fails to exhibit sufficient chemical resistance on a support on which a water-receptive undercoat layer is provided or on a support treated with a water-receptive silicate. Further, when an acid anhydride is added as a development accelerator to the photosensitive layer to improve sensitivity and development characteristics, such a photosensitive layer also fails to obtain sufficient chemical resistance.

An object of the present invention is to provide a positive type photosensitive planographic printing plate which can be developed with a developer having relatively low stimulating action on the skin and the mucous membrane to increase safety and simultaneously has sufficient image strength (impression capacity and chemical resistance).

As a result of intensive studies to achieve the above-mentioned object, the present inventors provide a photosensitive layer comprising a combination of a particular phenol-formaldehyde resin having a weight average molecular weight of 10,000 or more in which the content of components containing 3 or more aromatic groups in molecule is 90% by weight or more with an o-naphthoquinonediazide sulfonic acid ester of a polyhydroxy compound having a weight average molecular weight of 2,000 or more. This photosensitive layer can be developed with a developer of pH 12.5 or less and reach a practically usable level in chemical resistance, thus completing the present invention.

That is, this and other objects of the present invention have been attained by a photosensitive planographic printing plate comprising a photosensitive layer, wherein said photosensitive layer comprises (a) a phenol-formaldehyde resin having components containing 3 or more aromatic groups per molecule in an amount of 90% by weight or more and having a weight average molecular weight of 10,000 or more, and (b) an o-naphthoquinonediazide sulfonic acid ester of a polyhydroxy compound, having a weight average molecular weight of 2,000 or more.

More preferably, in the above-described photosensitive planographic printing plate, said photosensitive layer further comprises from 1 to 50% by weight of a film-forming resin which is other than a novolak resin, has at least one alkali-soluble group selected from the group consisting of an aromatic hydroxyl group, a carboxyl group, a sulfonamide group, and an N-sulfonylamide group, has a weight average molecular weight of from 10,000 to 100,000, and is soluble in an aqueous alkali of pH 12.5.

The photosensitive composition for the photosensitive planographic printing plate (hereinafter abbreviated as the "presensitized plate" or "PS plate") of the present invention is described in detail below.

### Photosensitive Composition:

The photosensitive composition used in the present invention comprises an o-quinonediazide compound and a high-molecular weight binder as main components.

### Binder:

The high-molecular weight binders for use in the present invention are novolak type phenol-formaldehyde resins having a weight average molecular weight of 10,000 or more in which the content of components-containing 3 or more aromatic groups in molecule is 90% by weight or more, preferably 100% by weight or less. The weight average molecular weight is preferably 25,000 or less. Hereinafter, in the present specification, the components containing 3 or more aromatic groups in molecule are referred to as "components containing 3 or more nuclei".

A molecular weight reduced to polystyrene by gel permeation chromatography (GPC) is herein defined as the weight average molecular weight.

The phenol-formaldehyde resins are prepared by an acid-catalyzed condensation of phenol with an aldehyde such as formaldehyde or paraformaldehyde. Particularly, the preparation of the phenol-formaldehyde resins having a weight average molecular weight of 10,000 or more which are used for the present invention is preferably carried out by using 0.7 to 0.9 mol of an aldehyde per mol of phenol. The amount of the aldehyde of less than 0.7 mol fails to obtain a satisfactory molecular weight, whereas the amount exceeding 0.9 mol is unpreferably liable to form a gel.

Acidic catalysts used for the condensation include hydrochloric acid, sulfuric acid, formic acid, acetic acid, and oxalic acid. Oxalic acid is preferred among these acids. When the phenol-formaldehyde resin thus prepared contains 10% by weight or more of components containing 2 or less nuclei, lower molecular weight components must be removed by fractional precipitation, fractional solution, column chromatography, or others to reduce the amount of the components containing 2 or less nuclei to 10% by weight or less.

The phenol-formaldehyde resin which contains 10% by weight or more of components containing 2 or less nuclei has high solubility, failing to obtain sufficient chemical resistance to the photosensitive layer. The phenol-formaldehyde resin not exceeding 10,000 in weight average molecular weight fails to obtain image strength sufficient to achieve the object of the present invention. Particularly, when an acid anhydride is added to the photosensitive layer to improve sensitivity and development characteristics as described later, when the surface of a support described later is treated with a water-receptive silicate, and further, when various undercoat layers are provided on the support, the phenol-formaldehyde resin which contains 10% by weight or more of components containing 2 or less nuclei or which has a weight average molecular weight not exceeding 10,000 also fails to obtain sufficient image strength.

The cresol-formaldehyde resins used as a binder for the customary positive type photosensitive planographic printing plates can not be developed with a developer of pH 12.5 or less, failing to achieve the object of the present invention.

The content of said phenol-formaldehyde resin having a molecular weight of 10,000 in the whole photosensitive composition used in the present invention is from 30 to 90% by weight, and more preferably from 40 to 70% by weight.

In some cases, other alkali-soluble resins than the novolak resins may be used together with them for the photosensitive composition used in the present invention. The alkali-soluble resins involve film-forming resins which are soluble in an aqueous alkali of pH 12.5 (herein, the resin soluble in an aqueous alkali of pH 12.5 means a resin, 30 g of which is added with stirring to 1 liter of an aqueous alkali of pH 12.5 and dissolves within 30 min, the aqueous alkali of pH 12.5 being prepared by dissolving 0.11 mol of sodium hydroxide and 0.4 mol of potassium chloride in water followed by adjusting the total volume to 1 liter with water), and which have a weight average molecular weight of 10,000 to 100,000, and contain, as a polymerizable component, at least one selected among monomers containing an alkali-soluble group shown in the following items (1) to (4):
(1) acrylamides, methacrylamides, acrylates, and methacrylates containing an aromatic hydroxyl group, and hydroxystyrenes, such as N-(4-hydroxyphenyl)acrylamide, N-(4-hydroxyphenyl)methacrylamide, o- , m-, and p-hydroxy-styrene, o- and m-bromo-p-hydroxy-styrene, o- and m-chloro-p-hydroxystyrene, and o-, m-, and p-hydroxyphenyl acrylate and methacrylate;
(2) unsaturated carboxylic acids such as acrylic acid, methacrylic acid, maleic acid, maleic anhydride and its half ester, itaconic acid, itaconic anhydride and its half ester;
(3) unsaturated sulfonamides containing an acrylamide structure such as N-(o-aminosulfonylphenyl)acrylamide, N-(m-aminosulfonylphenyl)acrylamide, N-(p-aminosulfonylphenyl)acrylamide, N-[l-(3-aminosulfonyl)naphthyl]acrylamide, and N-(2-aminosulfonylethyl)acrylamide;unsaturated sulfonamides containing a methacrylamide structure such as N-(o-aminosulfonylphenyl)methacrylamide, N-(m-aminosulfonylphenyl)methacrylamide, N-(p-aminosulfonylphenyl)methacrylamide, N-[1-(3-aminosulfonyl)naphthyl] methacrylamide, and N-(2-aminosulfonylethyl)methacrylamide; unsaturated sulfonamides containing an acrylate structure such as o-aminosulfonylphenyl acrylate, m-aminosulfonylphenyl acrylate, p-aminosulfonylphenyl acrylate, and 1-(3-aminosulfonylphenyl)naphthyl acrylate; and unsaturated sulfonamides containing a methacrylate structure such as o-aminosulfonylphenyl methacrylate, m-aminosulfonylphenyl methacrylate, p-aminosulfonylphenyl methacrylate, and 1-(3-aminosulfonylphenyl)naphthyl methacrylate; and
(4) phenylsulfonylacrylamides which may contain a substituent group like tosylacrylamide, and phenylsulfonylmethacrylamides which may contain a substituent group like tosylmethacrylamide.

Film-forming resins prepared by copolymerizing these monomers containing an alkali-soluble group with monomers shown in the following items (5) to (14) also are suitably used:
(5) acrylates and methacrylates containing an aliphatic hydroxyl group such as 2-hydroxyethyl acrylate and 2-hydroxyethyl methacrylate;
(6) (substituted) acrylic esters such as methyl acrylate, ethyl acrylate, propyl acrylate, butyl acrylate, amyl acrylate, hexyl acrylate, cyclohexyl acrylate, octyl acrylate, phenyl acrylate, benzyl acrylate, 2-chloroethyl acrylate, 4-hydroxybutyl acrylate, glycidyl acrylate, and N-dimethylaminoethyl acrylate;
(7) (substituted) methacrylates such as methyl methacrylate, ethyl methacrylate, propyl methacrylate, butyl methacrylate, amyl methacrylate, hexyl methacrylate, cyclohexyl methacrylate, octyl methacrylate, phenyl methacrylate, benzyl methacrylate, 2-chloroethyl methacrylate, 4-hydroxybutyl methacrylate, glycidyl methacrylate, N-dimethylaminoethyl methacrylate;
(8) acrylamides and methacrylamides such as acrylamide, methacrylamide, N-methylolacrylamide, N-methylolmethacrylamide, N-ethylacrylamide, N-ethylmethacrylamide, N-hexylacrylamide, N-hexylmethacrylamide, N-cyclohexylacrylamide, N-cyclohexylmethacrylamide, N-hydroxyethylacrylamide, N-hydroxyethylmethacrylamide, N-phenylacrylamide, N-phenylmethacrylamide, N-benzylacrylamide, N-benzylmethacrylamide, N-nitrophenylacrylamide, N-nitrophenylmethacrylamide, N-ethyl-N-phenylacrylamide, and N-ethyl-N-phenylmethacrylamide;
(9) vinyl ethers such as ethyl vinyl ether, 2-chloroethyl vinyl ether, hydroxyethyl vinyl ether, propyl vinyl ether, butyl vinyl ether, octyl vinyl ether, and phenyl vinyl ether;
(10) vinylates such as vinyl acetate, vinyl chloroacetate, vinyl butyrate, and vinyl benzoate;
(11) styrenes such as styrene, α-methylstyrene, methylstyrene, and chloromethylstyrene;
(12) vinyl ketones such as methyl vinyl ketone, ethyl vinyl ketone, propyl vinyl ketone, and phenyl vinyl ketone;
(13) olefins such as ethylene, propylene, isobutylene, butadiene, and isoprene; and
(14) N-vinylpyrrolidone, N-vinylcarbazole, 4-vinylpyridine, acrylonitrile, and methacrylonitrile.

These alkali-soluble film-forming resins are used singly or as a mixture of 2 or more kinds thereof. The content of the resin in the whole photosensitive composition is from 1 to 50% by weight.

Besides these copolymers, polyvinyl butyral resins, polyurethane resins, polyamide resins, and epoxy resins also can be used.

### o-Quinonediazide Compound:

o-Naphthoquinonediazide compounds which are another main component of the photosensitive composition used in the present invention are o-quinonediazide sulfonic acid esters of polyhydroxy compounds, the esters having a molecular weight of 2,000 or more, preferably 10,000 or less. Examples of the polyhydroxy compounds for use in the present invention include pyrogallol-acetone resins, phenol-formaldehyde resins, cresol-formaldehyde resins, hydroxy-styrene resins, and halogenated hydroxystyrene resins. In the present invention, the molecular weight of less than 2,000 fails to obtain sufficient image strength.

In the preparation of the o-naphthoquinonediazide compounds from these polyhydroxy compounds, an 1,2-diazonaphthoquinonesulfonic chloride is preferably used in an amount of from 0.2 to 1.2 equivalent, more preferably from 0.3 to 1.0 equivalent, to one hydroxyl group contained in a polyhydroxy compound. The 1,2-diazonaphthoquinone sulfonic chloride for use in the present invention is 1,2-diazonaphthoquinone-5-sulfonic chloride or 1,2-diazonaphthoquinone-4-sulfonic chloride.

The o-naphthoquinonediazide compound thus obtained is a mixture of compounds different from one another in position on the polyhydroxy compound into which an 1,2-diazonaphthoquinone sulfonic acid ester linkage is introduced and in amount of the linkage introduced. The content of a completely esterified compound in the mixture is preferably 5 mol% or more, and more preferably from 20 to 99 mol%, the completely esterified compound meaning that all the hydroxyl groups of the polyhydroxy compound are esterified to form a 1,2-diazonaphthoquinone sulfonic acid ester.

The content of the o-quinonediazide compound is preferably from 10 to 50% by weight, more preferably from 15 to 40% by weight, in the whole photosensitive composition.

In the present invention, compounds having a molecular weight of less than 2,000 which can be prepared by the reaction of polyhydroxy compounds with 1,2-diazonaphthoquinone sulfonic acids can be used together with the above-mentioned o-quinonediazide compounds, as long as the use of those compounds does not deteriorate the effect of the present invention. Examples of such o-quinonediazide compounds include those which are described in JP-A-51-139402, JP-A-58-150948, JP-A-58-203434, JP-A-59-165053, JP-A-60-121445, JP-A-60-134235, JP-A-60-163043, JP-A-61-118744, JP-A-62-10645, JP-A-62-10646, JP-A-62-153950, JP-A-62-178562, JP-A-64-76047, U.S. Patents 3,102,809, 3,126,281, 3,130,047, 3,148,983, 3,184,310, 3,188,210 and 4,639,406. The ratio of the o-quinonediazide compound used together is preferably 50% by weight or less, more preferably 30% by weight or less, to the whole o-quinonediazide compound.

### Sensitizing Agent:

To improve the ink receptivity of an image, the condensed products of phenols containing an alkyl group having 3 to 8 carbon atoms with formaldehyde such as t-butylphenol-formaldehyde resins and octylphenol-formaldehyde resins may be preferably used as described in U.S. Patent 4,123,279.

### Development Accelerator:

In the present invention, to improve sensitivity and development characteristics, cyclic acid anhydrides, phenols, and organic acids are preferably added to the photosensitive composition. Examples of the cyclic acid anhydrides include phthalic anhydride, tetrahydrophthalic anhydride, hexahydrophthalic anhydride, 3,6-endoxo-Δ⁴-tetrahydrophthalic anhydride, tetrachlorophthalic anhydride, maleic anhydride, chloromaleic anhydride,, α-phenylmaleic anhydride, succinic anhydride, and pyromellitic anhydride which are described in U.S. Patent 4,115,128.

Examples of the phenols include bisphenol A, p-nitrophenol, p-ethoxyphenol, 2,4,4'-trihydroxybenzophenone, 2,3,4-trihydroxybenzophenone, 4-hydroxybenzophenone, 4,4',4"-trihydroxytriphenylmethane, and 4,4',3",4"-tetrahydroxy-3,5,3',5'-tetramethyltriphenylmethane.

The organic acids-used in the present invention are sulfonic acids, sulfinic acids, alkyl sulfates, phosphonic acids, phosphoric esters, and carboxylic acids. Examples thereof include p-toluenesulfonic acid, dodecylbenzene-sulfonic acid, p-toluenesulfinic acid, ethyl sulfate, phenylphosphonic acid, phenylphosphinic acid, phenyl phosphate, diphenyl phosphate, benzoic acid, isophthalic acid, adipic acid, p-toluic acid, 3,4-dimethoxybenzoic acid, phthalic acid, terephthalic acid, 1,4-cyclohexene-2,2-dicaroxylic acid, erucic acid, lauric acid, n-undecanoic acid, and ascorbic acid, as described in JP-A-60-88942 and JP-A-2-96755.

The content of the above-mentioned cyclic acid anhydrides, phenols and organic acids is preferably from 0.05 to 15% by weight, more preferably from 0.1 to 5% by weight, in the photosensitive composition.

### Development Stabilizer:

To increase processing stability to development conditions (the so-called development latitude), nonionic surfactants as described in JP-A-62-251740 and JP-A-4-68355 or amphoteric surfactants as described in JP-A-59-121044 and JP-A-4-13149 can be added to the photosensitive composition used in the present invention.

Examples of the nonionic surfactants include sorbitan tristearate, sorbitan monopalmitate, sorbitan trioleate, stearic acid monoglyceride, polyoxyethylene sorbitan monooleate, and polyoxyethylene nonylphenyl ether.

Examples of the amphoteric surfactants include alkyldi(aminoethyl)glycine, alkylpolyaminoethylglycine hydrochloride, 2-alkyl-N-carboxyethyl-N-hydroxyethylimidazolium betaine, N-tetradecyl-N,N-betaine type surfactants (for example, Amorgen K (trade name) manufactured by Dai-ichi Kogyo Seiyaku Co., Ltd.), and alkylimidazoline type surfactants (for example, Lebon 15 (trade name) manufactured by Sanyo Chemical Industries, Ltd.).

The content of the nonionic or amphoteric surfactant is preferably from 0.05 to 15% by weight, more preferably from 0.1 to 5% by weight, in the photosensitive composition.

### Printing-out Agent and Dye:

Printing-out agents for obtaining a visible image just after exposure and dyes or pigments as image colorants can be added to the photosensitive composition used in the present invention.

Typical printing-out agents are combinations of acid-releasing compounds by exposure (photoacid-releasing agents) with salt-forming organic dyes. Examples thereof include combinations of o-naphthoquinonediazido-4-sulfonic halogenide with salt-forming organic dyes described in JP-A-50-36209 and JP-A-53-8128 and combinations of trihalomethyl compounds with salt-forming organic dyes described in JP-A-53-36223, JP-A-54-74728, JP-A-60-3626, JP-A-61-143748, JP-A-61-151644, and JP-A-63-58440. Such trihalomethyl compounds include oxazole type compounds and triazine type compounds, either of which is excellent in stability to time to give a clear printing-out image.

Other dyes than the above-mentioned salt-forming organic dyes also can be used as the image colorant. Suitable dyes, including the salt-forming organic dyes, are oil-soluble dyes and basic dyes. Examples thereof include Oil Yellow #101, Oil Yellow #103, Oil Pink #312, Oil Green BG, Oil Blue BOS, Oil Blue #603, Oil Black BY, Oil Black BS, Oil Black T-505 (manufactured by Orient Chemical Industries Co., Ltd.), Victoria Pure Blue, Crystal Violet (CI42555), Methyl Violet (CI42535), Ethyl Violet, Rhodamine B (CI145170B), Malachite Green (CI42000), and Methylene Blue (CI52015). In addition, dyes described in JP-A-62-293247 are particularly preferred.

### Coating Solvent:

The photosensitive composition used in the present invention prepared by dissolving the above-mentioned components in a solvent is applied to an aluminum plate used as a support. Organic solvents as described in JP-A-61-95463 are used as the solvent, singly or as a mixture thereof.

The photosensitive composition used in the present invention is dissolved or dispersed so as to be 2 to 50% by weight as a concentration of solid content, applied to the support, and then dried.

### Coating Amount:

Although the coating amount of the photosensitive composition which forms the photosensitive layer on the support depends on uses thereof, it is preferably from 0.3 to 4.0 g/m² in dry weight. A smaller coating amount requires a smaller quantity of exposure to obtain an image, but deteriorates film strength. Although a larger coating amount requires a larger quantity of exposure, it brings about a strong photosensitive film. For example, when the resulting product is used as a printing plate, it makes it possible to print a greater number of sheets (high impression capacity).

### Improvement in Quality of Coated Surface:

To improve the quality of a coated surface, surfactants like fluorine type surfactants as described in JP-A-62-170950 can be added to the photosensitive composition used in the present invention. The content of the surfactantsn is preferably from 0.001 to 1.0% by weight, more preferably from 0.005 to 0.5% by weight, in the whole photosensitive composition.

### Matting Layer:

To reduce the evacuation time in contact exposure using a vacuum frame and to control lack of sharpness on printing, a matting layer is preferably formed on the surface of the photosensitive layer formed as mentioned above. Examples thereof include matting layers as described in JP-A-50-125805, JP-B-57-6582, and JP-B-61-28986 and layers to which powdered solid is fused as described in JP-B-62-62337.

### Support:

Supports used for the presensitized plate of the present invention are dimensionally stable plates. Such supports include paper, paper laminated with plastics (for example, polyethylene, polypropylene, polystyrene), and metal plates formed of aluminum (including aluminum alloys), zinc, iron, or copper. Particularly, the effect of the present invention is greatly achieved by metal plates such as an aluminum plate. Suitable aluminum plates are a pure aluminum plate, plates of aluminum alloys in which a trace amount of the other atoms is contained in aluminum as the main component, and aluminum-laminated or aluminum-deposited plastic films. Examples of the other atoms contained in aluminum alloys include silicon, iron, manganese, copper, magnesium, chromium, zinc, bismuth, nickel, and titanium. The content of the other atoms in aluminum alloys is 10% by weight at the highest. Although pure aluminum is suitable for the present invention, aluminum contaminated with a trace amount of the other atoms is employed, because completely pure aluminum is difficult to manufacture in the refining technique. Thus, aluminum plates used in the present invention, which have no certain composition, are ones formed of the known, generally used materials. The thickness of the aluminum plates is from 0.1 to 0.6 mm.

To remove a rolling oil from the surfaces, if desired, the aluminum plates may undergo degreasing treatment by use of, for example, a surfactant, an organic solvent, or an aqueous alkali, prior to surface roughening.

Subsequently, the aluminum plates are subjected to surface roughening. Methods of the surface roughening include a mechanical method, an electrochemical method of dissolving the surface, and a chemical method of dissolving selectively the surface. As the mechanical method, there are methods known as ball abrasion, brush abrasion, blast abrasion and buff abrasion. The electrochemical surface roughening are carried out in a hydrochloric acid electrolyte or a nitric acid electrolyte by alternating current or by direct current. A combination of the mechanical method with the electrochemical method as disclosed in JP-A-54-63902 also can be used.

The aluminum plates thus surface-roughened are anodized, if desired, to improve the water receptivity and resistance to wear of the surface, after being etched with alkali and neutralized, as needed. Any of electrolytes which can form a porous oxide layer is used to anodize the aluminum plate. Sulfuric acid, phosphoric acid, oxalic acid, chromic acid, and mixed acids thereof are generally used for the purpose. The concentration of those electrolytes is suitably determined, depending upon the kind thereof.

Although the anodizing conditions vary with the electrolyte used, in general, the concentration of the electrolyte ranges from 1 to 80% by weight, the temperature of the electrolytic solution from 5 to 70°C, the current density from 5 to 60 A/dm², the voltage from 1 to 100 V, and the electrolytic time from 10 s to 5 min.

The amount of the oxide layer formed by anodizing is preferably 1.0 g/m² or more, and more preferably from 2.0 to 6.0 g/m². The amount not exceeding 1.0 g/m² results in insufficient impression capacity or in readily generating scratches on the non-image areas of the planographic printing plate. This often causes the so-called "scumming" in which ink sticks to the scratches on printing.

After being anodized, the surface of the aluminum plate is subjected to treatment for water wettability, as needed. The treatment used suitably in the present invention involves a method treating with an alkali metal silicate (for example, an aqueous solution of sodium silicate) as disclosed in U.S. Patents 2,714,066, 3,181,461, 3,280,734, and 3,902,734. In this method, the support is dipped or electrolyzed in the aqueous solution of sodium silicate.

In addition to these methods, there are also a method of treating with potassium fluorozirconate disclosed in JP-B-36-22063 and a method of treating with polyvinyl phosphonic acid as disclosed in U.S. Patents 3,276,868, 4,153,461 and 4,689,272.

### Organic Undercoat Layer:

Prior to the coating of the photosensitive layer, an organic undercoat layer is preferably formed in the photosensitive planographic printing plate of the present invention to decrease the residue of the photosensitive layer on the non-image areas. Examples of organic compounds used for forming the organic undercoat layer include phosphonic acids containing an amino group such as carboxymethyl-cellulose, dextrin, gum arabic, and 2-aminoethylphosphonic acid; organic phosphonic acids such as phenylphosphonic acid, naphthylphosphonic acid, alkylphosphonic acid, glycerophosphonic acid, methylenediphosphonic acid, and ethylenediphosphonic acid, in which these phosphonic acids each may contain a substituent group; organic phosphoric acids such as phenylphosphoric acid, naphthylphosphoric acid, alkylphosphoric acid, and glycerophosphoric acid, in which these phosphoric acids each may contain a substituent group; organic phosphinic acids such as phenylphosphinic acid, naphthylphosphinic acid, alkylphosphinic acid, and glycerophosphinic acid, in which these phosphinic acids may contain a substituent group; amino acids such as glycine and β-alanine; and amine hydrochlorides containing a hydroxyl group such as triethanolamine hydrochloride. These organic acids may be used as a mixture of 2 or more kinds thereof.

The organic undercoat layer can be formed according to the following methods. That is, one method is that the above-mentioned organic compound is dissolved in water, an organic solvent such as methanol, ethanol and methyl ethyl ketone, or a mixed solvent thereof, and the resulting solution is applied to an aluminum plate, and then dried; and another method is that the above-mentioned organic compound is dissolved in water, an organic solvent such as methanol, ethanol and methyl ethyl ketone, or a mixed solvent thereof, and an aluminum plate is dipped in the resulting solution to allow the organic compound to be adsorbed, washed with water, etc., and then dried to form the organic undercoat layer. In the former method, a solution containing 0.05 to 5% by weight of the above-mentioned compound can be applied by use of various methods. Examples of the methods include bar coater coating, whirl coating, spray coating, curtain coating. In the latter method, the concentration of the solution is from 0.01 to 20% by weight, and preferably from 0.05 to 5% by weight; the dipping temperature is from 20 to 90°C, and preferably from 25 to 50°C; the dipping time is from 0.1 s to 20 min, and preferably from 2 s to 1 min.

The solution used for this purpose can be adjusted to a range of pH 1 to 12 with a basic substance such as ammonia, triethylamine and potassium hydroxide, or an acidic substance such as hydrochloric acid and phosphoric acid. To improve the tone reproducibility of the photosensitive planographic printing plate, a yellow dye can also be added thereto.

The covering amount of the organic undercoat layer is suitably from 2 to 200 mg/m², and preferably from 5 to 100 mg/m². The covering amount of less than 2 mg/m² fails to obtain sufficient impression capacity. The covering amount exceeding 200 mg/m² also brings about the same result.

### Back Coat:

A back coat is formed on the backside of the support, as needed. Organic high-molecular weight compounds described in JP-A-5-45885 and covering layer formed of metal oxides which are obtained by hydrolysis and polycondensation of organic or inorganic metal compounds described in JP-A-6-35174 are preferably used as the back coat.

Among these covering layers, alkoxy compounds of silicon such as Si(OCH₃)₄, Si(OC₂H₅)₄, Si(OC₃H₇)₄, and Si(OC₄H₉)₄ are preferably used, because they are inexpensive and readily available, and the covering layers of metal oxides obtained from them have excellent resistance to the developers.

### Development:

The thus prepared presensitized plate is exposed to an active ray from a source such as a carbon-arc lamp, a mercury vapor lamp, a metal halide lamp, a xenon lamp, and a tungsten lamp through a transparent original and thereafter developed.

### Alkali Agent:

The presensitized plate of the present invention can be developed at relatively low pH. The developer is preferably adjusted to pH 10.0 to 12.7, and more preferably to pH 11.0 to 12.5.

Developers having such pH involve buffers consisting of weak acids and strong bases as alkali agents. The acid dissociation constant (pKₐ) of the weak acids used for such buffers is preferably from 10.0 to 13.3, and particularly preferably from 11.0 to 13.1. For example, sulfosalicylic acid which has a third dissociation constant of 11.7 can be preferably used. That is, polybasic acids which have at least one acid dissociation constant within the above range can be used for the present invention.

Such weak acids can be selected among ones described in Ionisation Constants of Organic Acids in Aqueous Solution (Permagon Press), and examples thereof include alcohols such as 2,2,3,3-tetrafluoropropanol-1 (pKₐ 12.74), trifluoro-ethanol (pKₐ 12.37) and trichloroethanol (pKₐ 12.24); aldehydes such as pyridine-2-aldehyde (pKₐ 12.68) and pyridine-4-aldehyde (pKₐ 12.05); sugars such as sorbitol (pKₐ 13.0), saccharose (pKₐ 12.7), 2-deoxyribose (pKₐ 12.61), 2-deoxyglucose (pKₐ 12.51), glucose (pKₐ 12.46), galactose (pKₐ 12.35), arabinose (pKₐ 12.34), xylose (pKₐ 12.29), fructose (pKₐ12.27), ribose (pKₐ 12.22), mannose (pKₐ 12.08), and L-ascorbic acid (pKₐ 11.34); compounds containing a phenolic hydroxyl group such as salicylic acid (pKₐ 13.0), 3-hydroxy-2-naphthoic acid (pKₐ 12.84), catechol (pKₐ 12.6), gallic acid (pKₐ 12.4), sulfosalicylic acid (pKₐ 11.7), 3,4-dihydoxybenzene sulfonic acid (pKₐ 12.2), 3,4-dihydroxybenzoic acid (pKₐ 11.94), 1,2,4-trihydroxybenzene (pKₐ 11.82), hydroquinone (pKₐ 11.56), pyrogaliol (pKₐ 11.34) and resorcinol (pKₐ 11.27); oximes such as 2-butanoneoxime (pKₐ 12.45), acetoxime (pKₐ 12.42), 1,2-cycloheptanedionedioxime (pKₐ 12.3), 2-hydroxybenzaldehydeoxime (pKₐ 12.10), dimethyl-glyoxime (pKₐ 11.9), ethanediamidedioxime (pKₐ 11.37), and acetophenoneoxime (pKₐ 11.35); amino acids such as 2-quinolone (pKₐ 11.76), 2-pyridone (pKₐ 11.65), 4-quinolone (pKₐ 11.28), 4-pyridone (pKₐ 11.12), 5-aminovaleric acid (pKₐ 10.77), 2-mercaptoquinoline (pKₐ 10.25), and 3-aminopropionic acid (pKₐ 10.24); nucleic acid-related substances such as fluorouracil (pKₐ13.0), guanosine (pKₐ12.6), uridine (pKₐ 12.6), adenosine (pKₐ 12.56), inosine (pKₐ 12.5), guanine (pKₐ 12.3), cytidine (pK, 12.2), cytosine (pKₐ 12.2), hypoxanthine (pKₐ 12.1), and xanthine (pKₐ 11.9); and other weak acids such as diethylaminomethylphosphonic acid (pKₐ 12.32), 1-amino-3,3,3-trifluorobenzoic acid (pKₐ 12.29), isopropylidenediphosphonic acid (pKₐ 12.10), l,l-ethylidene-phosphonic acid (pKₐ 11.54), 1,1-ethylidenephosphonic acid 1-hydroxy (pKₐ 11.52), benzimidazole (pKₐ 12.86), thiobenzamide (pKₐ 12.8), picolinethioamide (pKₐ 12.55), and barbituric acid (pKₐ 12.5).

The strong bases combined with these weak acids include sodium hydroxide, ammonium hydroxide, potassium hydroxide, and lithium hydroxide.

These alkali agents are used singly or as a mixture of 2 or more kinds thereof.

Among these, preferred alkaline buffers are combinations of sulfosalicylic acid, salicylic acid, saccharose, and sorbitol with sodium hydroxide and potassium hydroxide.

The alkaline buffers are adjusted to a preferred range of pH by the concentration and combination of these alkali agents. The range of pH is preferably from 10.0 to 12.7, and more preferably from 11.0 to 12.5.

Any of known aqueous alkalis adjusted to pH 10.0 to 12.7 can also be used as the developer and its replenisher. Examples thereof include inorganic alkali agents such as sodium silicate, potassium silicate, sodium tertiary phosphate, potassium tertiary phosphate, ammonium tertiary phosphate, sodium secondary phosphate, potassium secondary phosphate, ammonium secondary phosphate, sodium carbonate, potassium carbonate, ammonium carbonate, sodium hydrogen-carbonate, potassium hydrogencarbonate, ammonium hydrogen-carbonate, sodium borate, potassium borate, ammonium borate, sodium hydroxide, ammonium hydroxide, potassium hydroxide, and lithium hydroxide; and organic alkali agents such as monomethylamine, dimethylamine, trimethylamine, monoethyl-amine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, and pyridine.

### Surfactant:

In order to promote development, to disperse sediment in the developer, and to increase the ink receptivity at the image areas of the printing plate, various surfactants and organic solvents can be added to the developer and its replenisher, as needed. Preferred surfactants are anionic, cationic, nonionic, and amphoteric surfactants.

Examples of preferred surfactants include nonionic surfactants such as polyoxyethylene alkyl ethers, polyoxyethylene alkyl phenol ethers, polyoxyethylene polystyryl phenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylenated castor oils, polyoxyethylene glycerin fatty acid partial esters, fatty acid dietanolamides, N,N-bis(2-hydroxyalkyl)amines, polyoxyethylene alkylamines, triethanolamine fatty acid esters, and trialkylamineoxides; anionic surfactants such as fatty acid salts, abietates, hydroxyalkanesulfonates, alkanesulfonates, dialkylsulfosuccinates, straight-chain alkylbenzenesulfonates, branched-chain alkylbenzene-sulfonates, alkylnaphthalenesulfonates, alkylphenoxy-polyoxyethylene propylsulfonates, polyoxyethylene alkyl-sulfophenyl ether salts, N-methyl-N-oleyltaurine sodium salt, N-alkylsulfosuccinmonoamide disodium salts, petroleum sulfonates, sulfonated beef tallow oil, sulfuric ester salts of fatty acid alkyl esters, alkyl sulfuric ester salts, polyoxyethylene alkyl ether sulfuric ester salts, fatty acid monoglyceride sulfuric ester salts, polyoxyethylene alkyl phenyl ether sulfuric ester salts, polyoxyethylene styryl phenyl ether sulfuric ester salts, alkyl phosphoric ester salts, polyoxyethylene alkyl ether phosphoric ester salts, polyoxyethylene alkyl phenyl ether phosphoric ester salts, partially saponified products of styrene/maleic anhydride copolymers, partially saponified products of olefin/maleic anhydride copolymers, and condensed products of naphthalenesulfonic acid salts with formaldehyde; cationic surfactants such as alkylammonium salts, quaternary ammonium salts such as tetrabutylammonium bromide, polyoxyethylene alkylammonium salts, and polyethylene polyamine derivatives; and amphoteric surfactants such as carboxy betaines, aminocarboxylic acids, sulfo betaines, amino sulfuric esters, and imidazolines. In the above-mentioned surfactants, the term polyoxyethylene means polyoxyalkylene such as polyoxymethylene, polyoxy-propylene and polyoxybutylene, and surfactants containing them also are included in the scope of the surfactants used in the present invention.

More preferred surfactants are fluorine type surfactants containing a perfluoroalkyl group in molecule. Examples of such fluorine type surfactants include anionic surfactants such as perfluoroalkylcarboxylic salts, perfluoroalkyl-sulfonic salts and perfluoroalkyl phosphoric esters; amphoteric surfactants such as perfluoroalkyl betaine; cationic surfactants such as perfluoroalkyltrimethylammonium salts; and nonionic surfactants such as perfluoroalkylamine oxides, perfluoroalkylethylene oxide adducts, oligomers containing a perfluoroalkyl group and a hydrophilic group, oligomers containing a perfluoroalkyl group and a lipophilic group, oligomers containing a perfluoroalkyl group, a hydrophilic group and a lipophilic group, and urethanes containing a perfluoroalkyl group and a lipophilic group.

The above-mentioned surfactants are used singly or as a mixture of two or more kinds thereof. The content of the surfactant in the developer is preferably from 0.001 to 10% by weight, and more preferably from 0.01 to 5% by weight.

### Development Stabilizer:

Various development stabilizers are added to the developer and its replenisher used in the present invention. Preferred examples thereof include polyethylene glycol adducts of sugaralcohol described in JP-A-6-282079, tetraalkylammonium salts such as tetrabutylammonium hydroxide, phosphonium salts such as tetrabutylphosphonium bromide, and iodonium salts such as diphenyliodonium chloride.

Further, anionic surfactants and amphoteric surfactants described in JP-A-50-51324, water-soluble cationic polymers described in JP-A-55-95946, and water-soluble amphoteric high-molecular weight electrolytes described in JP-A-56-142528 can also be used as the development stabilizer.

Furthermore, examples of the other development stabilizers used in the present invention include alkylene glycol adducts of organic boron compounds described in JP-A-59-84241, water-soluble surfactants of a polyoxyethylene or polyoxypropylene block polymerization type described in JP-A-60-111246, alkylenediamine compounds substituted by polyoxyethylene or polyoxypropylene described in JP-A-60-129750, polyethylene glycol having a weight average molecular weight of 300 or more described in JP-A-61-215554, fluorine type surfactants containing a cationic group described in JP-A-63-175858, water-soluble ethylene oxide adducts prepared by adding 4 mol or more of ethylene oxide to acids or alcohols which is described in JP-A-2-39157, and water-soluble poly-alkylene compounds.

### Organic Solvent:

Organic solvents are further added to the developer and replenisher, as needed. The solubility of such organic solvents in water is preferably 10% by weight or less, and more preferably 5% by weight or less. Examples thereof include 1-phenylethanol, 2-phenylethanol, 3-phenyl-1-propanol, 4-phenyl-1-butanol, 4-phenyl-2-butanol, 2-phenyl-1-butanol, 2-phenoxyethanol, 2-benzyloxyethanol, o-methoxy-benzyl alcohol, m-methoxybenzyl alcohol, p-methoxybenzyl alcohol, benzyl alcohol, cyclohexanol, 2-methylcyclohexanol, 3-methylcyclohexanol, 4-methylcyclohexanol, N-phenylethanolamine, and N-phenyldiethanolamine. The content of the organic solvent is from 0.1 to 5% by weight, based on the total weight of the developer in service. There is a close relation between the content of the organic solvent and that of the surfactant. It is preferred that, as the content of the organic solvent is increased, the content of the surfactant is also increased. The reason for this is that, when a smaller amount of the surfactant is used together with a larger amount of the organic solvent, the organic solvent is not completely dissolved so that good development characteristics can not be expected to be secured.

### Reducing Agent:

Reducing agents are further added to the developer and replenisher used in the present invention. The addition thereof is effective in control of stains on a printing plate, particularly when the photosensitive planographic printing plate of a negative type which contains a photo-sensitive diazonium salt is developed. Examples of preferred organic reducing agents include phenolic compounds such as thiosalicylic acid, hydroquinone, Metol, methoxyquinone, resorcin, and 2-methylresorcin; and amine compounds such as phenylenediamine and phenylhydrazine. Preferred inorganic reducing agents are sodium, potassium and ammonium salts of inorganic acids such as sulfite, hydrogen-sulfite, phosphite, hydrogenphosphite, dihydrogenphosphite, thiosulfate, and dithionite. Among these reducing agents, sulfites have a markedly excellent effect on the control of stains. The developer on service preferably contains 0.05 to 5% by weight of these reducing agents.

### Organic Carboxylic Acid:

Organic carboxylic acids can be further added to the developer and replenisher used in the present invention. Preferred organic carboxylic acids are aliphatic and aromatic carboxylic acids having 6 to 20 carbon atoms. Examples of aliphatic carboxylic acids include caproic acid, enanthylic acid, caprylic acid, lauric acid, myristic acid, palmitic acid and stearic acid. Particularly preferred aliphatic carboxylic acids are alkanoic acids having 8 to 12 carbon atoms. Unsaturated aliphatic acids containing a double bond in carbon chain and branched-chain aliphatic acids may also be used.

The aromatic carboxylic acids are compounds having a benzene ring, a naphthalene ring or an anthracene ring which is substituted by a carboxylic group. Examples of the aromatic carboxylic acids include o-chlorobenzoic acid, p-chlorobenzoic acid, o-hydroxybenzoic acid, p-hydroxybenzoic acid, o-aminobenzoic acid, p-amino-benzoic acid, 2,4-dihydroxybenzoic acid, 2,5-dihydroxybenzoic acid, 2,6-dihydroxybenzoic acid, 2,3-dihydroxybenzoic acid, 3,5-dihydroxybenzoic acid, gallic acid, 1-hydroxy-2-naphthoic acid, 3-hydroxy-2-naphthoic acid, 2-hydroxy-1-naphthoic acid, 1-naphthoic acid, and 2-naphthoic acid. Naphthoic acids are particularly effective.

To increase solubility in water, the above-mentioned aliphatic and aromatic carboxylic acids are preferably used as their sodium, potassium, or ammonium salts. The content of the organic carboxylic acid in the developer used in the present invention is not particularly limited. However, the content of less than 0.1% by weight does not offer sufficient effect, whereas the content exceeding 10% by weight fails to offer more improved effect and, in addition, may prevent other additives from dissolving in the developer. Therefore, the content of the organic carboxylic acid in the developer is preferably from 0.1 to 10% by weight, and more preferably from 0.5 to 4% by weight, based on the developer in service.

### Others Components:

Antifoamers, water softeners, and others can also be further added to the developer and replenisher used in the present invention. Examples of the water-softeners include polyphosphoric acid and its sodium, potassium and ammonium salts; amino polycarboxylic acids such as ethylenediaminetetraacetic acid, diethylenetriaminepentaacetic acid, triethylenetetraminehexaacetic acid, hydroxyethylethylenediaminetriacetic acid, nitrilotriacetic acid, 1,2-diaminocyclohexanetetraacetic acid, and 1,3-diamino-2-propanoltetraacetic acid, and their sodium, potassium and ammonium salts; amino phosphonic acids such as aminotri(methylenephosphonic acid), ethylenediaminetetra(methylenephosphonic acid), diethylenetriaminpenta(metylenephosphonic acid), triethylenetetraminehexa(metylenephosphonic acid), hydroxyethylethylenediaminetri(methylenephosphonic acid), and 1-hydroxyethane-1,1-diphosphonic acid, and their sodium, potassium and ammonium salts.

Although the most suitable content of these water softeners varies with their ability to chelate and with the hardness and amount of hard water, the content is generally from 0.01 to 5% by weight, and more preferably from 0.01 to 0.5% by weight, based on the developer in service. The content of less than 0.01% by weight fails to achieve the desired purpose, whereas the content exceeding 5% by weight have an adverse effect on the image areas like discoloration.

Although one of other components than the above-mentioned components for the developer and replenisher is water, other various additives known in this industry can be further added, as needed.

The respective concentrated solutions of the developer and replenisher which contain a smaller amount of water than those of the developer and replenisher in service and are diluted with water prior to their use, are advantageous in transport thereof. They are suitably concentrated to an extent that the components thereof each are not separated out.

### Development and Post Treatment:

The presensitized plate which is processed with the thus formulated developer may be post-treated with washing water, rinse containing a surfactant and others, and a finisher or a protective gum liquid containing gum arabic, starch derivatives, or the like as a main component. The post treatment of the presensitized plate of the present invention is carried out by variously combining these treatments.

To rationalize or standardize the prepress processing in the platemaking and printing industries, an automatic processor for a presensitized plate has been widely used in recent years. The automatic processor, which principally consists of a development part and a post treatment part, contains a conveying system for an exposed presensitized plate and processing tanks and spraying systems for the treatment liquids described above, and develops and post-treats the presensitized plate by spraying the respective pumped treatment liquids from nozzles, while horizontally conveying the presensitized plate. In addition, a method of processing an exposed presensitized plate by dipping in the respective treatment liquids in the tanks, while conveying the presensitized plate by guide rolls, and a method of supplying a smaller constant amount of washing water to the presensitized plate after development in which the waste water generated from the washing water is recycled as water for diluting a stock developer are known in late years.

In such automatic processing, the exposed presensitized plates can be treated while supplying the respective replenishers to the treatment liquids, depending on the treated amount and operating time. The so-called throwaway processing system can also be adopted, in which the exposed presensitized plates are substantially treated with the respective virgin treatment liquids.

The planographic printing plate thus prepared which is set on an offset press is used to print a great number of sheets.

The positive type photosensitive planographic printing plate of the present invention can be treated with a safe developer having relative low pH and satisfy both the development characteristics and the image strength (impression capacity and chemical resistance).

The present invention is illustrated with reference to examples in detail below. All percents, parts and ratios are by weight, unless otherwise indicated.

### EXAMPLE 1

A surface of a 0.24 mm-thick aluminum plate was grained with an aqueous suspension of 400-mesh pumistone using a nylon brush and then fully washed with water. The aluminum plate was etched by dipping in 10% sodium hydroxide at 70°C for 20 s, washed with running water, neutralized and washed with 20% nitric acid, and then washed with water. The aluminum plate was subsequently subjected to electrolytic surface-roughening treatment in a 0.7% nitric acid at a quantity of electricity of 400 coulombs/dm² using alternating wave shape current of sine wave under the condition of V_{A} = 12.7 V. This substrate was treated with a 10% aqueous solution of sodium hydroxide so that the amount of dissolved aluminum on the surface thereof became 0.9 g/m². The substrate was washed with water, neutralized and washed with a 20% nitric acid to remove smuts, and anodized in a 18% aqueous solution of sulfuric acid so that the amount of an oxide layer became 3 g/m². Subsequently, the substrate was then subjected to treatment for water wettability in a 2% aqueous solution of sodium silicate at 35°C. The support thus prepared was coated with undercoat solution having the following composition so that the dry weight became 10 mg/m², and dried at 90°C for 1 min to form a undercoat layer.

| Undercoat Solution a: | |
|---|---|
| Penylphosphonic acid | 0.06 g |
| Sulfuric Acid | 0.12 g |
| Methanol | 100 g |

Subsequently, a photosensitive solution having the following composition was prepared and applied to the above-mentioned substrate so that the dry weight became 1.8 g/m².

| Photosensitive Solution: | |
|---|---|
| Phenol-Formaldehyde Resin | 1.9 g |
| (Content of components containing 3 or more nuclei: 94.6% by weight, Molecular Weight: 12,500) | |
| Esterified Product from 1,2-Diazonaphthoquinone-5-sulfonyl Chloride and Pyrogallol-Acetone Resin (Molecular Weight: 2,500) | 0.76 g |
| Tetrahydrophthalic Anhydride | 0.2 g |
| 4-[p-N-(p-Hydroxybenzoyl)aminophenyl] -2,6-bis(trichloromethyl)-s-triazine | 0.02 g |
| Victoria Pure Blue BOH (Manufactured by Hodogaya Chemical Co., Ltd.) Megafac F-177 (Fluorine Type | 0.03 g |
| Surfactant Manufactured by Dainippon Ink and Chemicals, Inc.) | 0.006 g |
| Methyl Ethyl Ketone | 15 g |
| Propylene glycol Monomethyl Ether | 15 g |

On the photosensitive layer thus prepared, a matting layer-forming resin solution was sprayed in the following manner.

A 12% aqueous solution of a copolymer of methyl methacrylate, ethyl acrylate and acrylic acid (weight ratio of the charged monomers = 65 : 20 : 15) which is partly converted into sodium salt is prepared as the matting layer-forming resin solution. Coating was carried out by use of a rotary spray electrostatic coating machine under the following conditions.

| | |
|---|---|
| Number of Revolution at a Spray Head | 25,000 rpm |
| Flow Velocity of the Resin Solution | 40 ml/min |
| Voltage Applied to the Spray Head | -90 KV |
| Ambient Temperature on Spraying | 25°C |
| Relative Humidity | 50% |

Steam was sprayed on the coated surface in 2.5 s after coating to be allowed to swell and then dried in 3 s after swelling by blowing of warm air of a temperature of 60°C and humidity of 10% for 5 s. The height of the matting was about 6 µm, the size about 30 µm, and the number 150 per mm². Presensitized plate A thus prepared was cut to a size 1,003 mm × 800 mm, which was exposed to light from a 3 kw-metal halide lamp at a distance of 1 m for 60 s through an original film.

The developer tank of a commercially available automatic processor PS-900D containing the developer tank of a dipping type (manufactured by Fuji Photo Film Co., Ltd.) was charged with 20 liter of the following developer A (pH 12.3), and kept at 35°C. The second tank of PS-900D was charged with 8 liter of city water and the third tank with 8 liter of a finishing liquid prepared by diluting FP-2 (manufactured by Fuji Photo Film Co., Ltd.) with water in a ratio of 1 : 1.

| Developer A: | |
|---|---|
| D-Saccharose | 5.1% |
| Sodium Hydroxide | 0.46% |
| Sodium Carbonate | 0.74% |
| Tetrabutylammonium Bromide | 0.03% |
| Water | 93.67% |

The exposed presensitized plate was developed by passing through the automatic processor PS-900D. Then, the above-mentioned presensitized plate was exposed to the light through a step tablet (having 15 steps. Difference in optical density between the steps is 0.15) was simultaneously developed, - and the number of steps leaving an image corresponding to quantity of the light on the plate (number of steps clear/solid) was determined. The values were defined as the sensitivity in cases where presensitized plate A was treated with developer A, and shown in Table 1.

The planographic printing plate thus prepared was set on an offset press Sprint 25 (manufactured by Komori Printing Press Co., Ltd.) to be put into press. Half of the surface of the printing plate was wiped with a sponge which soaked up Ultra Plate Cleaners (manufactured by ABC Chemical Co., Ltd.) in every 5,000 printed sheets to clean. Results of this printing are shown in Tables 1 to 3.

Presensitized plate A which can be developed at relatively low pH (pH 12.3) offers impression capacity and chemical resistance equivalent to those of the presensitized plates which are widely used in the market, the plates being developed at relatively higher pH (pH 13.0).

### EXAMPLE 2

Presensitized plate A was treated in a manner similar to that of Example 1, except that the following developer B was used in place of developer A. As a result of evaluation, the printing plate was found to have satisfactory impression capacity and chemical resistance similarly to Example 1.

| Developer B: | |
|---|---|
| Sulfosalicylic acid dihydrate | 12.7% |
| Sodium Hydroxide | 6.1% |
| Tetrabutylammonium Bromide | 0.03% |
| Water | 81.17% |

### EXAMPLE 3

Presensitized plate A was treated in a manner similar to that of Example 1, except that the following developer C was used in place of developer A. As a result of evaluation, the printing plate was found to have satisfactory impression capacity and chemical resistance similarly to Example 1.

| Developer C: | |
|---|---|
| Aqueous Solution of Potassium Silicate Containing 1.4% by weight of SiO₂ (Molar Ratio [SiO₂]/[K₂O] = 1.7) | 100% |
| Tetrabutylammonium Bromide | 0.03% |

### EXAMPLE 4

Presensitized plate B was prepared according to the same method as that used in Example 1, except that the o-quinone-diazide compound used for the photosensitive solution of Example 1 was replaced by an esterified product (molecular weight: 3,200) from 1,2-diazonaphthoquinone-5-sulfonyl chloride and a m-cresol-formaldehyde resin, and treated in a manner similar to that of Example 1 to evaluate the resulting planographic printing plate. The printing plate was found to have satisfactory impression capacity and chemical resistance similarly to Example 1.

### COMPARATIVE EXAMPLE 1

Presensitized plate C was prepared according to the same method as that used in Example 1, except that the phenol-formaldehyde novolak resin used for the photosensitive solution of Example 1 was replaced by a phenol-formaldehyde novolak resin having a molecular weight of 8,400 in which the content of components each containing 3 or more nuclei is 88.6% by weight, and treated in a manner similar to that of Example 1 to evaluate the resulting planographic printing plate. The printing plate prepared from presensitized plate C had insufficient impression capacity, and particularly, heavily deteriorated chemical resistance.

### EXAMPLE 5

The support which was prepared according to the same method as that used in Example 1 till the anodizing step was coated with undercoat solution b having the following composition so that the dry weight became 10 mg/m², and then dried at 90°C for 1 min to form a undercoat layer.

| Undercoat Solution b: | |
|---|---|
| β-Alanine | 0.5 g |
| Methanol | 95 g |
| Water | 5 g |

Subsequently, presensitized plate D in which a photo-sensitive layer and a matting layer were formed according to the same methods as those used in Example 1, respectively, was prepared, and treated with developer A similarly to Example 1 to evaluate the resulting printing plate. As a result, the printing plate was found to have sufficient impression capacity and chemical resistance.

### COMPARATIVE EXAMPLE 2

Presensitized plate E was prepared according to the same method as that used in Example 5, except that the phenol-formaldehyde novolak resin was replaced by a phenol-formaldehyde novolak resin having a molecular weight of 8,400 in which the content of components each containing 3 or more nuclei is 88.6% by weight, and treated in a manner similar to that of Example 5 to evaluate the resulting planographic printing plate. The printing plate prepared from presensitized plate E was insufficient in impression capacity and chemical resistance, and particularly, the chemical resistance was heavily deteriorated.

### COMPARATIVE EXAMPLE 3

Presensitized plate F was prepared according to the same method as that used in presensitized plate E in Comparative Example 2, except that the undercoating was omitted from the preparation of the support of presensitized plate E and that tetrahydrophthalic anhydride was excluded from the photo-sensitive solution. The printing plate which was prepared by treating in a manner similar to that of Example 5 was found to have better impression capacity and chemical resistance than those of the printing plate in Comparative Example 2, but with the performance inferior to that of Example 5.

### EXAMPLE 6

A support which was prepared in a manner similar to that of Example 1 till the anodizing step was coated with undercoat solution c having the following composition so that the dry weight became 10 mg/m², and then dried at 90°C for 1 min to form a undercoat layer.

| Undercoat Solution c: | |
|---|---|
| Triethanolamine hydrochloride | 0.5 g |
| Methanol | 95 g |
| Water | 5 g |

Subsequently, the photosensitive solution having the following composition was prepared, and applied to the above-mentioned substrate so that the dry weight became 1.8 g/m² to form a photosensitive layer.

| Photosensitive Solution: | |
|---|---|
| Phenol-Formaldehyde Resin (Content of Components Containing 3 or More Nuclei:95.5% by Weight. Molecular Weight 13,500) | 1.9 g |
| Esterified Product from 1,2-Diazonaphthoquinone-5-sulfonyl Chloride and Pyrogallol-Acetone Resin (Molecular Weight:2,500) | 0.76 g |
| Tetrahydrophthalic Anhydride | 0.2 g |
| 4-[p-N-(p-Hydroxybenzoyl)aminophenyl]-2,6-bis(trichloromethyl)-s-triazine | 0.02 g |
| Victoria Pure Blue BOH (Manufactured by Hodogaya Chemical Co., Ltd.) | 0.03 g |
| Megafac F-177 (Fluorine Type Surfactant Manufactured by Dainippon Ink and Chemicals, Inc.) | 0.006 g |
| Methyl Ethyl Ketone | 15 g |
| Propylene Glycol Monomethyl Ether | 15 g |

A matting layer-forming resin solution was sprayed on the surface of the thus prepared photosensitive layer in a manner similar to that of Example 1 to prepare presensitized plate G having a matting layer formed, which was treated with developer A similarly to Example 1. As a result of evaluation, the resulting printing plate was found to have sufficient impression capacity and chemical resistance.

### COMPARATIVE EXAMPLE 4

Presensitized plate H was prepared according to the same method as that used in Example 6, except that the o-quinone-diazide compound in the photosensitive solution of Example 6 was replaced by an esterified product (average molecular weight: 870) from 1,2-diazonaphthoquinone-5-sulfonyl chloride and trihydroxybenzophenone, and treated in a manner similar to that of Example 6. As a result of evaluation, the resulting planographic printing plate was found to have markedly deteriorated impression capacity and chemical resistance.

### COMPARATIVE EXAMPLE 5

Presensitized plate I was prepared according to the same method as that used in Example 6, except that the phenol-formaldehyde novolak resin in the photosensitive solution of Example 6 was replaced by a m-cresol-formaldehyde resin (molecular weight: 4,800, the content of components each containing 3 or more nuclei: 86.5% by weight). Presensitized plate I was treated in a manner similar to that of Example 6, but exposed areas thereof were not dissolved, failing to develop.

### EXAMPLE 7

Presensitized plate J was prepared according to the same method as that used in Example 1, except that a photo-sensitive sensitive solution having the following composition was used, and evaluated similarly to Example 1. As a result, the printing plate was found to have markedly improved chemical resistance.

| Photosensitive Solution: | |
|---|---|
| Phenol-Formaldehyde Resin (Molecular Weight: 12,500. Content of Components Containing 3 or More Nuclei: 92.3% by weight) | 1.7 g |
| Copolymer of Methyl Methacrylate and Methacrylic Acid (Ratio of Charged Monomers: 76 : 24. Molecular Weight: 60,000) | 0.2 g |
| Esterified Product from 1,2-Diazonaphthoquinone-5-sulfonyl Chloride and Pyrogallol-Acetone Resin (Molecular Weight: 2,500) | 0.76 g |
| Tetrahydrophthalic Anhydride | 0.2 g |
| 4-[p-N-(p-Hydroxybenzoyl)aminophenyl]-2,6-bis(trichloromethyl)-s-triazine | 0.02 g |
| Victoria Pure Blue BOH (Manufactured by Hodogaya Chemical Co., Ltd.) | 0.03 g |
| Megafac F-177 (Fluorine Type Surfactant Manufactured by Dainippon Ink and Chemical, Inc.) | 0.006 g |
| Methyl Ethyl Ketone | 15 g |
| Propylene Glycol Monomethyl Ethe | 15 g |

### EXAMPLE 8

Presensitized plate K was prepared according to the same method as that used in Example 1, except that a photo-sensitive solution having the following composition was used, and evaluated similarly to Example 1. As a result, the printing form was found to have markedly improved chemical resistance.

| Photosensitive Solution: | |
|---|---|
| Phenol-formaldehyde Resin (Molecular Weight: 12,500. Content of Components Containing 3 or More Nuclei: 92.3% by weight) | 1.7 g |
| Copolymer of Tosylmethacylamide, Ethyl Acrylate and Acrylonitrile (Molecular Weight: 83,000. Ratio of Charged Monomers: 30 : 50 :20) | 0.2 g |
| Esterified Product from 1,2-Diazonaphtho-quinone-5-sulfonyl Chloride and Pyrogallol-acetone Resin (Molecular Weight: 2,500) | 0.76 g |
| Tetrahydrophthalic Anhydride | 0.2 g |
| 4-[p-N-(p-Hydroxybenzoyl)aminophenyl]-2,6-bis(trichloromethyl)-s-triazine | 0.02 g |
| Victoria Pure Blue BOH (Manufactured by Hodogaya Chemical Co., Ltd.) | 0.03 g |
| Megafac F-177 (Fluorine Type Surfactant Manufactured by Dainippon Ink and Chemicals, Inc.) | 0.006 g |
| Methyl Ethyl Ketone | 15 g |
| Propylene Glycol Monomethyl Ether | 15 g |

Results of the examples and comparative examples are shown in Tables 1 to 3.

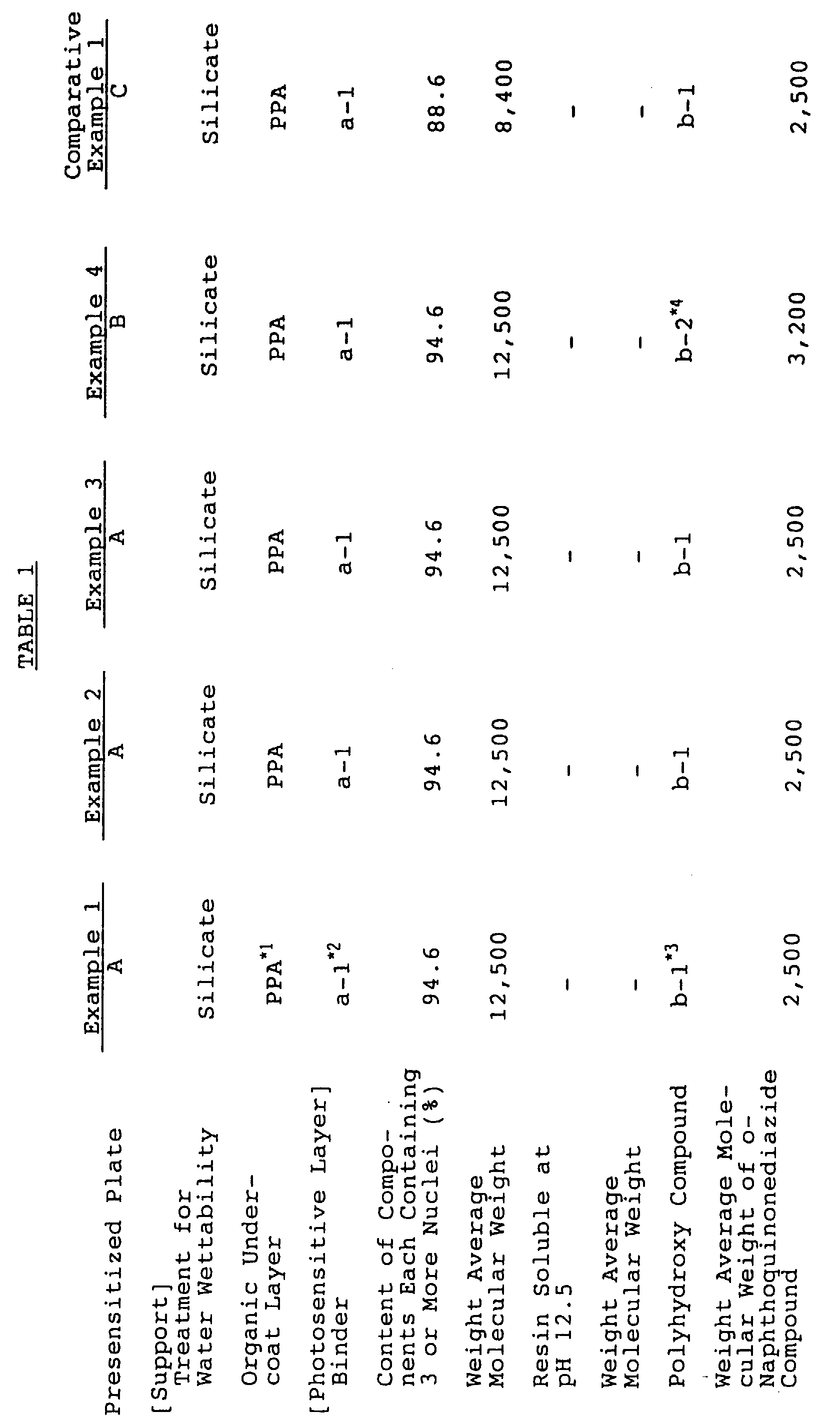

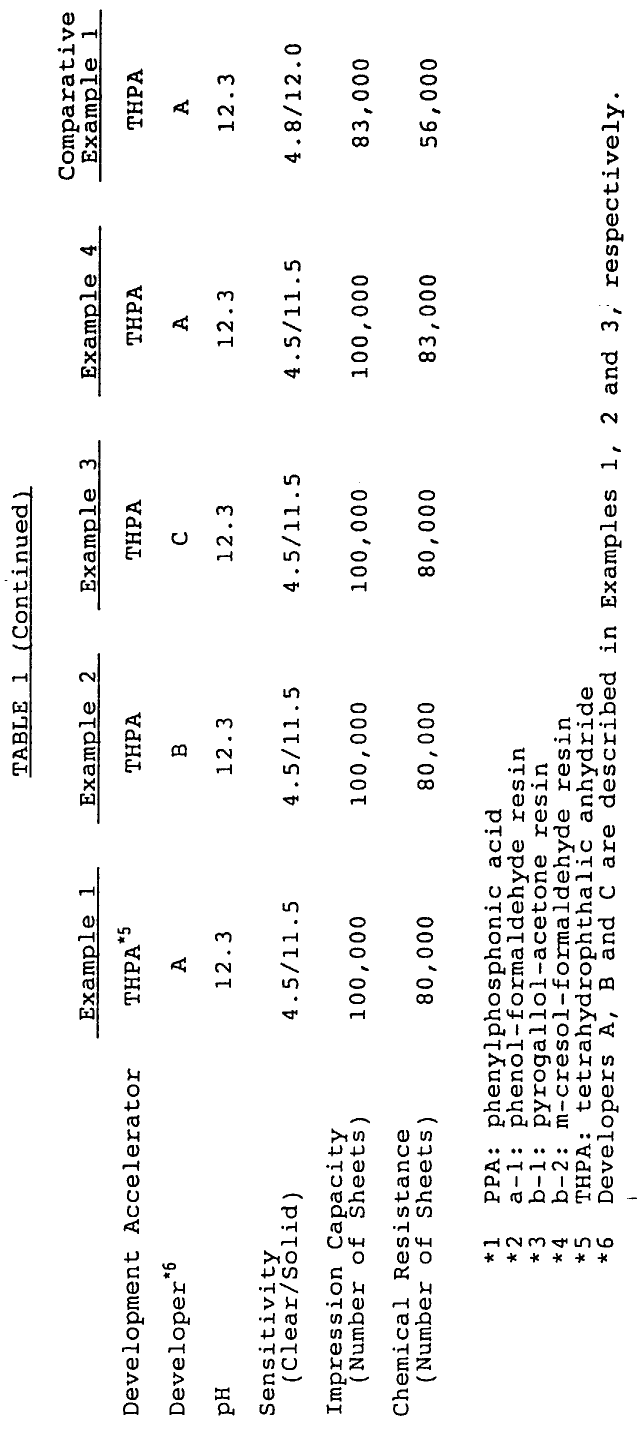

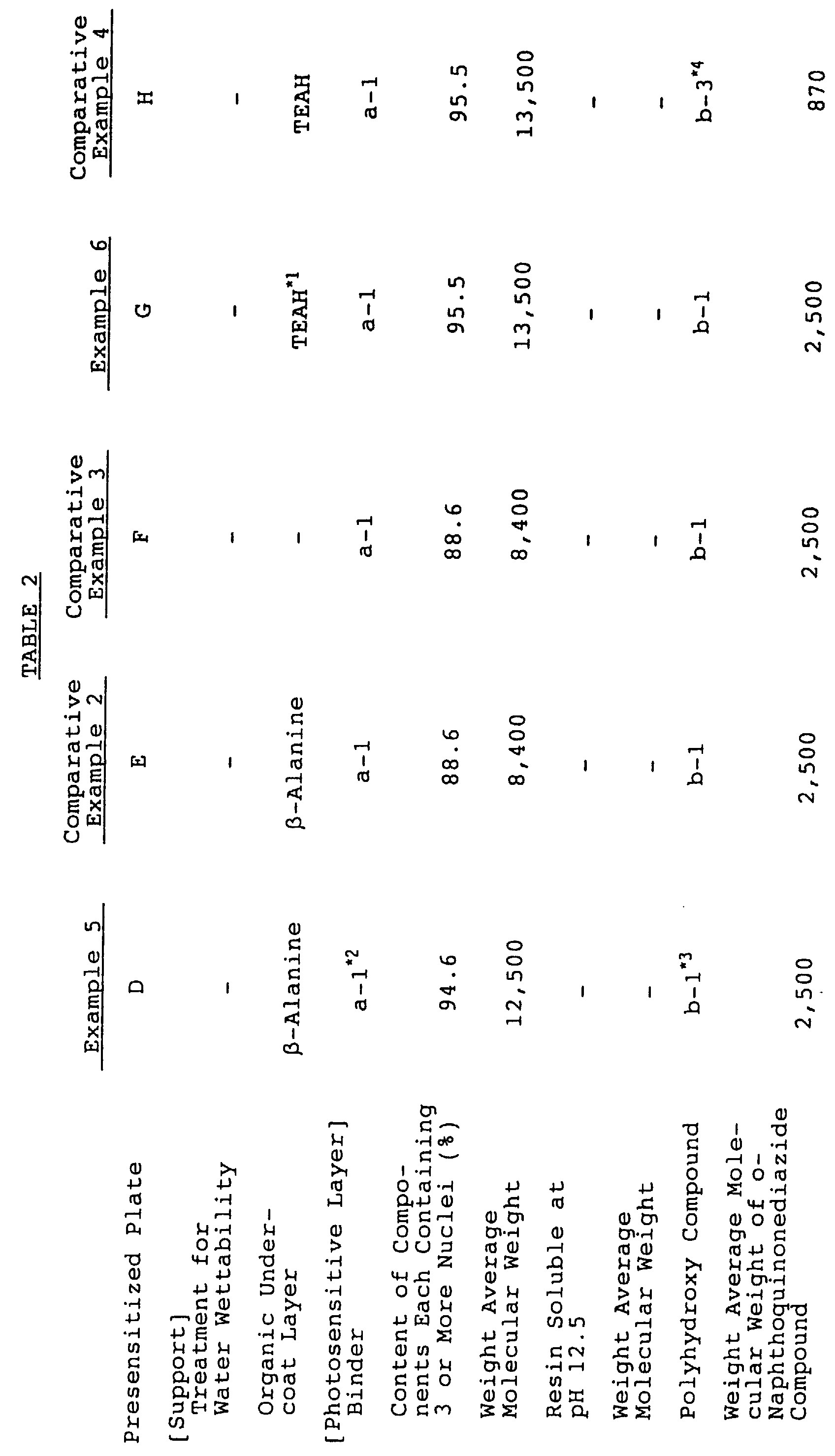

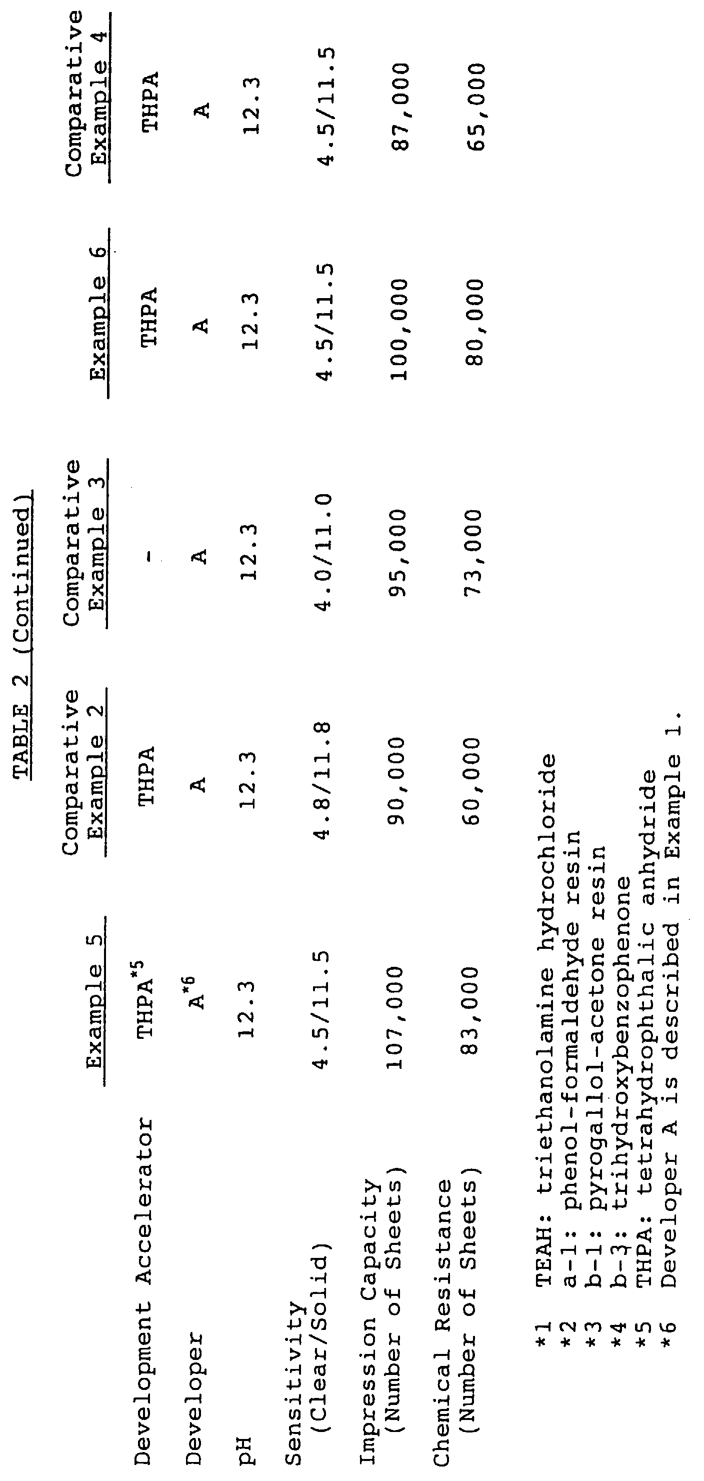

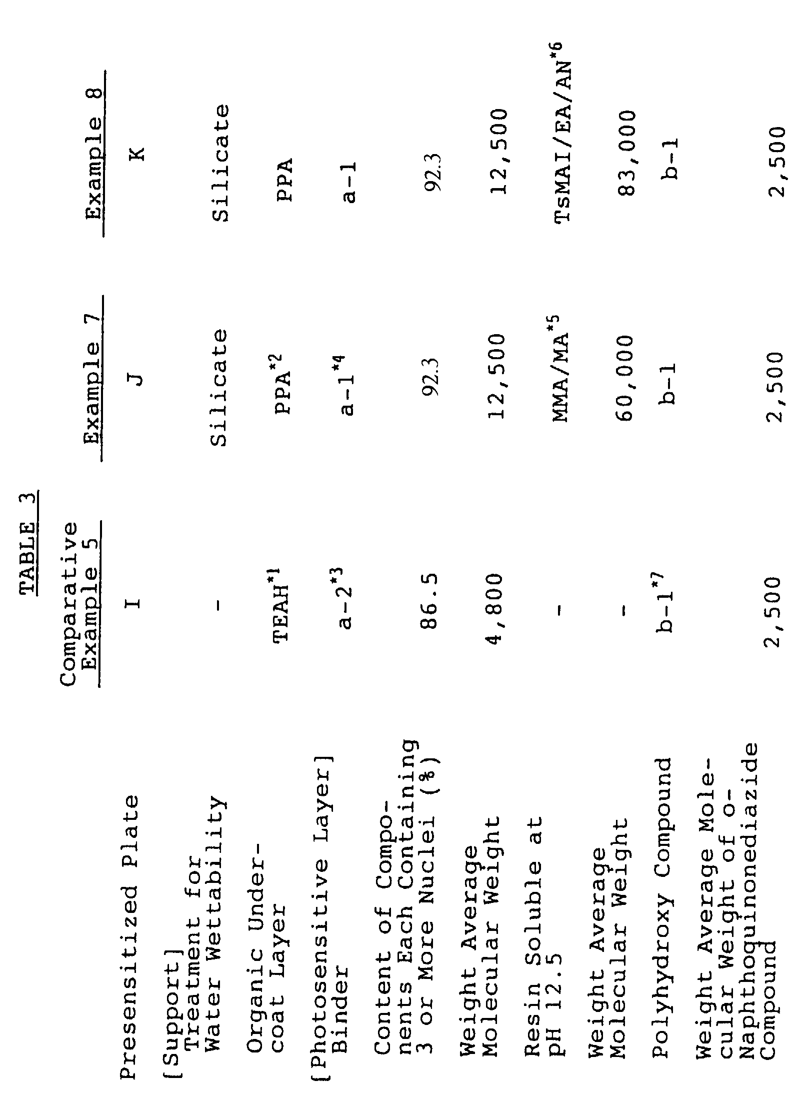

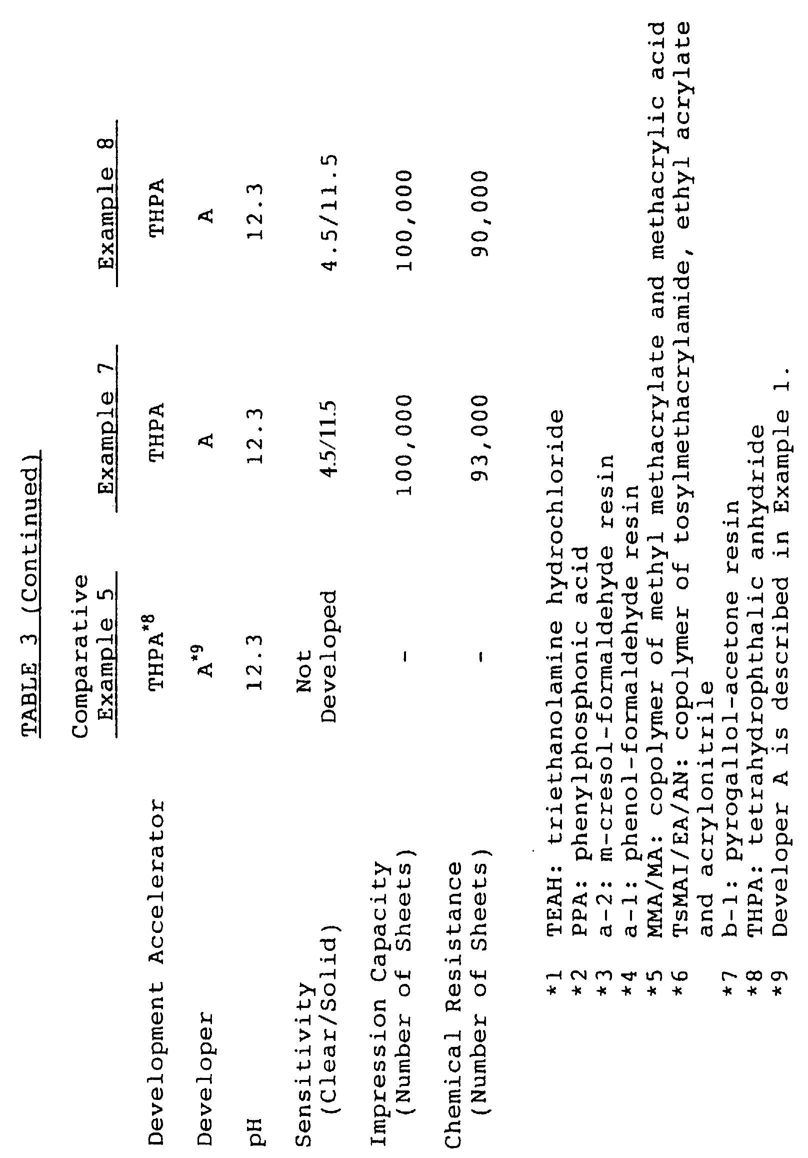

Any of the examples of the present invention shows that the resulting presensitized plates satisfy both the development characteristics at relatively low pH and the film strength (impression capacity and chemical resistance), and have printing performance almost equivalent to that of customary presensitized plates which are treated with developers of higher pH.

## Claims

1. A photosensitive planographic printing plate comprising a photosensitive layer, wherein said photosensitive layer comprises (a) a phenol-formaldehyde resin having components containing 3 or more aromatic groups per molecule in an amount of 90% by weight or more and having a weight average molecular weight of 10,000 or more, and (b) an o-naphthoquinonediazide sulfonic acid ester of a polyhydroxy compound, having a weight average molecular weight of 2,000 or more.

2. The photosensitive planographic printing plate as claimed in claim 1, wherein said photosensitive layer further comprises from 1 to 50% by weight of a film-forming resin which is other than a novolak resin, has at least one alkali-soluble group selected from the group consisting of an aromatic hydroxyl group, a carboxyl group, a sulfonamide group, and an N-sulfonylamide group, has a weight average molecular weight of from 10,000 to 100,000, and is soluble in an aqueous alkali of pH 12.5.

## Patentansprüche

1. Lichtempfindliche Flachdruckplatte, umfassend eine lichtempfindliche Schicht, wobei die lichtempfindliche Schicht
(a) ein Phenol-Formaldehydharz mit Komponenten mit 3 oder mehr aromatischen Resten pro Molekül in einer Menge von 90 Gew.-% oder mehr und mit einem Gewichtsmittel des Molekulargewichts von 10.000 oder mehr und
(b) einen o-Naphthochinondiazidsulfonsäureester einer Polyhydroxyverbindung mit einem Gewichtsmittel des Molekulargewichts von 2.000 oder mehr umfaßt.

2. Lichtempfindliche Flachdruckplatte nach Anspruch 1, wobei die lichtempfindliche Schicht außerdem 1 bis 50 Gew.-% eines Film-bildenden Harzes umfaßt, das von einem Novolakharz verschieden ist, und mindestens einen Alkali-löslichen Rest, ausgewählt aus der Gruppe bestehend aus einem aromatischen Hydroxylrest, einem Carboxylrest, einem Sulfonamidrest und einem N-Sulfonamidrest, und ein Gewichtsmittel des Molekulargewichts von 10.000 bis 100.000 hat und in einer wäßrigen Alkalilösung mit einem pH-Wert von 12,5 löslich ist.

## Revendications

1. Plaque d'impression planographique photosensible comprenant une couche photosensible, caractérisée en ce que ladite couche photosensible comprend (a) une résine phénol-formaldéhyde ayant des constituants contenant 3 groupes aromatiques ou plus par molécule en une quantité de 90 % en poids ou plus et ayant une masse moléculaire moyenne en poids de 10 000 ou plus, et (b) un ester d'acide o-naphtoquinonediazide sulfonique d'un composé polyhydroxylé, ayant une masse moléculaire moyenne en poids de 2 000 ou plus.

2. Plaque d'impression planographique photosensible selon la revendication 1, caractérisée en ce que ladite couche photosensible comprend en outre de 1 à 50 % en poids d'une résine filmogène qui est différente d'une résine novolaque, a au moins un groupe soluble en milieu alcalin choisi dans le groupe constitué par un groupe hydroxyle aromatique, un groupe carboxyle, un groupe sulfonamide, et un groupe N-sulfonylamide, a une masse moléculaire moyenne en poids de 10 000 à 100 000, et est soluble dans un milieu alcalin aqueux de pH 12,5.
